Europäisches Patentamt

European Patent Office

Office européen des brevets

(11) Veröffentlichungsnummer : **0 057 254 B1**

# EUROPÄISCHE PATENTSCHRIFT

(45) Veröffentlichungstag der Patentschrift :
**30.07.86**

(51) Int. Cl.⁴ : **H 01 L 21/00**

(21) Anmeldenummer : **81108138.9**

(22) Anmeldetag : **09.10.81**

(54) Verfahren zur Erzeugung von extremen Feinstrukturen.

(30) Priorität : **03.02.81 DE 3103615**

(43) Veröffentlichungstag der Anmeldung :
**11.08.82 Patentblatt 82/32**

(45) Bekanntmachung des Hinweises auf die Patenterteilung : **30.07.86 Patentblatt 86/31**

(84) Benannte Vertragsstaaten :
**DE FR GB IT**

(56) Entgegenhaltungen :
**APPLIED PHYSICS LETTERS, Band 34, Nr. 1, Januar 1979, Seiten 28-30, New York, USA E.C. JELKS et al.: "A simple method for fabricating lines of 0.15-micro width using optical lithography"**
**IEEE TRANSACTIONS ON ELECTRON DEVICES, Band ED-22, Juni 1975, Seiten 358-360, New York, USA R.H. DEAN et al.: "Submicrometer self-aligned dual-gate GaAs FET"**

(73) Patentinhaber : **Siemens Aktiengesellschaft Berlin und München Wittelsbacherplatz 2 D-8000 München 2 (DE)**

(72) Erfinder : **Kraus, Friedrich, Dr. rer. nat. Phys. Frühlingstrasse 27a D-8012 Riemerling (DE)**

## Beschreibung

Die Erfindung betrifft ein Verfahren zur Erzeugung von extremen Feinstrukturen auf einem Substrat und von einer Maske mit extremen Feinstrukturen nach dem Oberbegriff des Anspruchs 1.

Feinstrukturen auf Halbleiterscheiben werden fotolithografisch häufig mittels Abhebetechnik hergestellt, da sich die üblichen anderen Ätzverfahren wegen der auftretenden Unterätzung zur Herstellung von Feinstrukturen gewöhnlich nicht eignen. Bei der Herstellung von Feinstrukturen, die Dimensionen kleiner als 1 μm aufweisen, stört jedoch die Beugung des bei fotolithografischen Verfahren verwendeten UV-Lichts. Durch Übergang zu kurzwelligerem Licht wie Röntgenlicht oder Elektronenstrahlen läßt sich diese Grenze der Technik zwar überwinden. Diese Technik ist jedoch sehr teuer und aufwendig, weshalb sie zur Massenherstellung von Halbleiterbauelementen im allgemeinen nicht verwendet wird.

Aus « Applied Physics Letters », Band 34, Nr. 1, Januar 1979, Seiten 28 bis 30, ist ein Verfahren nach dem Oberbegriff des Anspruchs 1 bekannt. Nach Fig. 1 dieser Veröffentlichung wird auf ein Substrat eine Aluminiumschicht aufgebracht, die mit einem Fotolack bedeckt wird. Dieser Fotolack wird so strukturiert, daß auf der Aluminiumschicht ein Fotolackstreifen stehenbleibt. Auf diesen Fotolackstreifen und auf den freiliegenden Teil der Aluminiumschicht wird mittels Schrägbedampfung eine erste Titanschicht abgeschieden. Sodann wird in der Lücke zwischen dem Fotolackstreifen und der auf dem freiliegenden Teil der Aluminiumschicht aufliegenden Titanschicht der dort freiliegende Teil der Aluminiumschicht weggeätzt. Auf das so entstandene Gebilde wird mittels parallel zur Substratnormalen erfolgenden Bedampfung eine zweite Titanschicht aufgedampft. Dadurch wird direkt auf dem Halbleitersubstrat ein Titankontakt erzeugt. Schließlich wird der Fotolack abgehoben und die Aluminiumschicht weggeätzt.

Aus « IEEE Transactions on Electron Devices », Band ED-22, Juni 1975, Seiten 358 bis 360, New York, USA, ist ein Verfahren zur Erzeugung von extremen Feinstrukturen auf einem Substrat bekannt. Anhand von Fig. 1 dieser Veröffentlichung ist erläutert, daß mittels insgesamt vier Fotomasken eine Struktur erzeugt wird, bei der zuerst eine Mesa-Ätzung eines Halbleitersubstrats erfolgt, daß anschließend eine Titan-Palladium-Goldschicht unter einem Winkel von 65° gegen die Substratnormale aufgedampft wird, daß anschließend unter einem Winkel von 75° gegen die Substratnormale in der entgegengesetzten Richtung wiederum eine Titan-Palladium-Goldschicht aufgedampft wird, daß anschließend in der so entstandenen Lücke zwischen den aufgedampften Schichten und der Mesa-Stufe Halbleitermaterial aus dem Substrat weggeätzt wird, daß anschließend mittels parallel zur Substratnormale erfolgender Bedampfung ein Kontaktmetall in dieser Lücke auf dem Halbleitersubstrat aufgebracht wird.

Beiden genannten Veröffentlichungen ist gemeinsam, daß bei den dabei beschriebenen Verfahren, die Rand-Kanten-Fotolackschichten verwenden, Verstopfungen der als Aufdampfblende wirkenden Öffnung über der Lücke auftreten können.

Bei den aus dem Stand der Technik bekannten Verfahren wird eine Randverwischung des Metallkontakts der Feinstrukturen bewirkt infolge der Blendenwirkung der Öffnung zwischen den Aufdampfschichten bzw. zwischen den Aufdampfschichten und dem sehr dicken Fotolackstreifen. Beim Stand der Technik befindet sich diese Öffnung in einem relativ großen Abstand zu demjenigen Bereich auf dem Halbleitersubstrat, auf dem das Kontaktmetall abgeschieden werden soll. Bei einer üblichen Aufdampfquellengeometrie ist beim Stand der Technik eine Verwischung des Randes eines aufzubringenden Metallkontakts in der Größenordnung von 1/10 der Höhe des zu erzeugenden Metallkontakts unvermeidlich.

Bei dem Verfahren nach dem Stand der Technik ist der Widerstand des auf das Halbleitersubstrat aufgedampften Kontaktstreifens umgekehrt proportional dem unmittelbaren Kontaktquerschnitt mit dem Substrat. Ein kleiner Querschnitt des unmittelbaren Kontakts mit dem Substrat bei gleichzeitig kleinem Widerstand des Kontakts läßt sich beim Stand der Technik nicht verwirklichen.

Aufgabe der vorliegenden Erfindung ist es daher, ein Verfahren anzugeben, mit dem sich Kontaktstrukturen oder Masken auf Substraten technisch einfach und billig abscheiden lassen mit kleinsten Strukturdimensionen von 0,1 μm bis 1 μm, wobei gleichzeitig der elektrische Widerstand der erzeugten Kontaktstrukturen möglichst gering, d. h. der Metallquerschnitt möglichst groß ist.

Diese Aufgabe wird erfindungsgemäß durch ein Verfahren nach dem Anspruch 1 gelöst.

Wird eine relativ dicke strukturierte Maske, wie das z. B. bei einer Fotolackmaske der Fall ist, mit einer solchen Feinheit abgeschieden, daß die von der Maske gebildeten Lücken Dimensionen der Größenordnung von 1 μm aufweisen, und wird anschließend eine Materie-Abscheidung unter einem bestimmten Winkel auf dieser Maske vorgenommen, so ergeben sich Materie-Abscheidungen innerhalb der Maskenvertiefungen, die von den Fotolackrändern her nur einen Teil der Vertiefungen überdecken, während wegen der Schattenbildung ein Teil der Vertiefungen zum jeweils anderen Fotolackrand hin von Materie freibleibt. Diese in den Fotolacklücken erzeugte zweite Maske kann anschließend entweder als Maske zur Erzeugung von Kontakten dienen oder aber es kann mittels dieser zweiten Maske eine dritte Maske in ähnlicher Weise wie die zweite Maske abgeschieden werden. Diese Methode kann mehrfach wiederholt werden. Durch die in den Lücken der Fotolackmaske abgeschiedene Maske lassen sich somit Maskenlücken erzeugen, die sicher kleiner sind als 1 μm. Insbesondere lassen sich dadurch sowohl Maskenlücken wie auch Kontaktstrukturen mit 0,1 μm bis 1 μm Breite herstellen. Ein nachfolgendes Bedampfen mit Kontaktmaterial erzeugt ausreichend hohe Strukturen, so daß der sich ergebende Leitbahnwiderstand möglichst gering ist.

Verglichen mit dem Aufwand, den Röntgenstrahltechniken bzw. Elektronenstrahltechniken zur Erzeugung derartiger Strukturen erfordern, ist der Aufwand des erfindungsgemäßen Verfahrens verschwindend gering.

Es ist vorteilhaft, daß das Substrat ein Halbleitersubstrat ist, das mit einer oder mehreren Schichten versehen sein kann, und daß zu der Materialabscheidung ein zur Maskenherstellung geeignetes Material und/oder ein Kontaktmaterial verwendet wird. In der Halbleitertechnik sind vornehmlich Halbleitersubstrate mit Kontaktschichten zu versehen. Die Beschichtung eines Halbleitersubstrats mit einer oder mehreren Schichten vor der Anbringung von Kontaktstrukturen ist oftmals für das Herstellungsverfahren vorteilhaft. Das erfindungsgemäße Verfahren beschränkt sich jedoch nicht auf die Verwendung von Halbleitersubstraten.

Gemäß dem beanspruchten Verfahren ist es möglich, daß auf einer Halbleitersubstratoberfläche eine Isolatorschicht, z. B. bestehend aus $Si_3N_4$ und/oder $SiO_2$ und/oder SiO und/oder $Al_2O_3$, abgeschieden wird, daß darüber in an sich bekannter Weise eine Fotolackschicht abgeschieden und mittels Fototechnik strukturiert wird, daß in und auf die Fotolackmaske unter einem bestimmten geeigneten Winkel ätzresistentes Material, z. B. bestehend aus Titan (Ti), abgeschieden wird, daß danach eine Ätzung, z. B. mittels Plasmaätzung, derjenigen Teile der Isolatorschicht erfolgt, die durch Schattenwirkung infolge der gerichteten Abscheidung von ätzresistenten Material nicht bedeckt sind, daß anschließend auf die von Isolatormaterial freigeätzte Halbleiteroberfläche Kontaktmaterial, z. B. mittels Aufdampfen, abgeschieden wird, daß anschließend z. B. mittels Abhebetechnik die Fotolackschichten sowie die darauf befindlichen Kontaktmaterialschichten entfernt werden. Mit diesem Verfahren können Halbleiterscheiben insbesondere bestehend aus Galliumarsenid (GaAs) z. B. mit linienförmigen Metallkontakten von einer Breite von 0,1 μm bis 1 μm versehen werden, die z. B. als Gates für Feldeffekttransistoren verwendet werden können. Der elektrische Widerstand der Metallkontakte ist wegen der großen Querschnittsfläche in vorteilhafter Weise gering.

Nach dem beanspruchten Verfahren ist es auch möglich daß auf eine Halbleiteroberfläche Schichten z. B. bestehend aus einer ersten Titanschicht und einer Schicht aus ätzbarem Material wie Kupfer oder eine Schicht bestehend aus einem veraschbaren Material wie Lack aufgebracht werden, daß darüber eine Schicht, z. B.

bestehend aus einer zweiten Titanschicht, abgeschieden wird, daß darüber eine Fotolackmaske in an sich bekannter Weise abgeschieden wird, daß danach in den von der Fotolackmaske freigelegten Teilen die zweite Titanschicht, z. B. mittels Ätzung, entfernt wird, daß danach eine dritte Titanschicht unter einem bestimmten Winkel in und auf der Fotolackmaske abgeschieden wird, daß danach die freiliegenden Teile derjenigen Schicht entfernt werden, die sich unterhalb der dritten Titanschicht befindet, wobei im Falle einer Kupferschicht eine Sputterätzung möglich ist, im Falle einer Lackschicht eine Veraschung erfolgen kann, daß danach Kontaktmaterial auf die freigelegte Halbleiteroberfläche bzw. auf die Oberfläche der ersten Titanschicht, z. B. mittels Aufdampfen, abgeschieden wird, daß anschließend z. B. mittels Abhebetechnik Fotolackschichten sowie die darauf befindlichen Kontaktmaterialschichten entfernt werden, daß danach die zweite Titanschicht mittels Titanätze abgeätzt wird, daß danach bei einer auf dem Halbleiterkörper angebrachten Lackschicht diese abgelöst bzw. verascht wird, oder daß bei einer verwendeten ersten Titanschicht und einer Kupferschicht auf der Halbleiteroberfläche zunächst die Kupferschicht z. B. mittels Sputtern entfernt wird und anschließend die erste Titanschicht z. B. mittels Titanätze abgeätzt wird.

Auch mit dieser Ausgestaltung des erfindungsgemäßen Verfahrens lassen sich insbesondere auf Galliumarsenid (GaAs)-Halbleitersubstraten sehr feine linienförmige Metallkontakte von einer Breite von 0,1 μm bis 1 μm erzeugen.

Auch für andere Halbleitersubstrate sind die erfindungsgemäßen Verfahren brauchbar.

Nach dem erfindungsgemäßen Verfahren sind in vorteilhafter Weise gut produzierbare Linienkontakte mit Breiten von 0,1 μm bis 1 μm herstellbar. Insbesondere lassen sich hiernach rauscharme Galliumarsenid (GaAs)-Feldeffekttransistoren mit kleinen Gatelängen fertigen.

Nachfolgend wird die Erfindung an Hand der Zeichnung und von Ausführungsbeispielen näher erläutert.

Es zeigen :

Figuren 1 bis 3 ein erstes Ausführungsbeispiel nach dem erfindungsgemäßen Verfahren,

Figuren 4 bis 8 ein zweites Ausführungsbeispiel nach dem erfindungsgemäßen Verfahren.

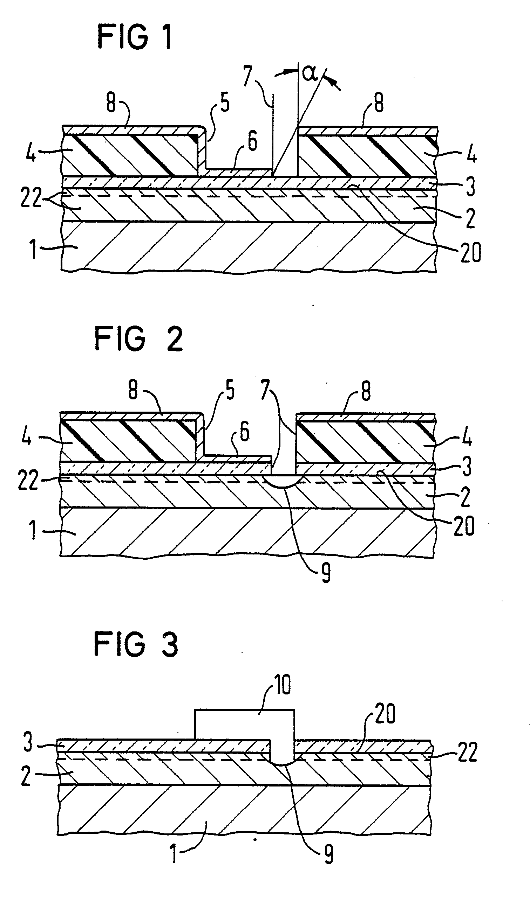

Fig. 1 zeigt ein Substrat 1, das einseitig mit einer Halbleiterschicht 2 versehen ist. Diese weist an der Oberfläche 20 eine stark dotierte Schicht 22 auf, wodurch eine gute Kontaktierung von darauf vorgesehenen Kontakten gewährleistet wird. Auf der Halbleiterschicht 2 ist eine Isolatorschicht 3, z. B. bestehend aus $Si_3N_4$ und/oder $SiO_2$ und/oder SiO und/oder $Al_2O_3$, abgeschieden. Auf der Isolatorschicht 3 ist eine Fotolackmaske 4 abgeschieden. In den Lücken 5 der Fotolackmaske 4 wird unter einem Winkel α ein ätzresistentes Material, z. B. Titan (Ti), abgeschieden, so daß sich innerhalb der Lücken 5 die Schichten 6 bilden. Wegen der Anwendung einer gerichteten Bedampfung bedeckt die Schicht 6 nicht die gesamte Isolatorschicht 3 in der Lücke 5, sondern erzeugt im Schattenbereich zwischen der Fotolackmaske 4 und der Schicht 6 eine Lücke 7. Außer der Schicht 6 bilden sich bei der Abscheidung von ätzresistentem Material Schichten 8 auf der Fotolackmaske 4.

In den folgenden Fig. 2 bis 8 sind gleiche Gegenstände aus Fig. 1 mit gleichen Bezugszeichen versehen und werden nicht nochmals erläutert.

Fig. 2 zeigt eine Anordnung wie Fig. 1, bei der innerhalb der Lücke 7 die darunter liegende Isolatorschicht 3 weggeätzt ist. Bei dieser Ätzung sind auch Teile der Halbleiterschicht 2 entfernt, weshalb sich in der Halbleiterschicht 2 innerhalb der Lücke 7 eine Versenkung 9 ausgebildet hat.

Fig. 3 stellt eine Anordnung nach Fig. 2 dar, bei der Kontakte 10 durch eine ganzflächige Bedampfung der Anordnung nach Fig. 2 in den Versenkungen 9 und gegebenenfalls auch auf den Schichten 6 entstanden sind. Die Fotolackmaske 4 nach Fig. 2 mit darauf befindlichen Schichten 8 wurden entfernt, was z. B. mittels Abhebetechnik nach der Abscheidung der Kontakte 10 erfolgen kann.

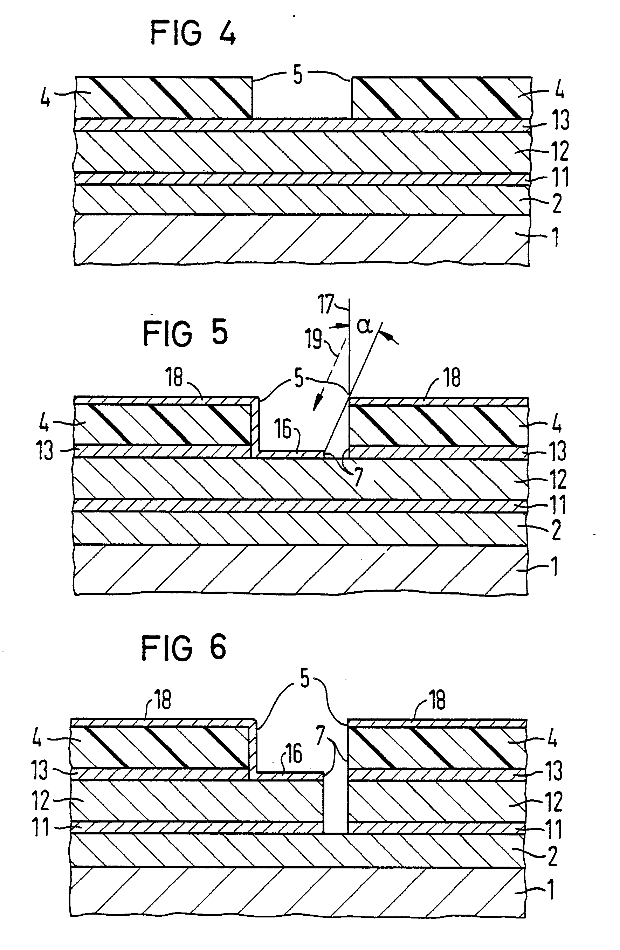

Bei Fig. 4 ist im Gegensatz zu Fig. 1 auf die Halbleiterschicht 2 eine erste Titanschicht 11 und auf diese wiederum eine Kupferschicht 12 und darüber wiederum eine zweite Titanschicht 13 aufgebracht. Auf der zweiten Titanschicht 13 befindet sich eine Fotolackmaske 4, die Lücken 5 aufweist.

Fig. 5 unterscheidet sich von Fig. 4 dadurch, daß die Teile der zweiten Titanschicht 13 in den Lücken 5 der Fotolackmaske 4 z. B. mittels Ätzen entfernt wurden und eine gerichtete Titanabscheidung unter einem Winkel α gegen die Scheibensenkrechte vorgenommen wurde, so daß sich innerhalb der Lücken 5 der Fotolackmaske 4 eine dritte Titanschicht 16 bzw. auf der Fotolackmaske 4 eine dritte Titanschicht 18 bildet. Die Richtung der dritten Titanabscheidung ist durch den Pfeil 19 angedeutet. Im Schattenbereich der gerichteten Abscheidung entstehen die Lücken 7.

In Fig. 6 sind gegenüber Fig. 5 die unterhalb der Lücke 7 liegenden Teile der Kupferschicht 12 und der ersten Titanschicht 11 z. B. mittels Ätzen entfernt, so daß die Lücke 7 bis hinunter zur Halbleiterschicht 2 reicht. Die Ätzung kann, falls erwünscht, so durchgeführt werden, daß auch Teile der Halbleiterschicht 2 mit entfernt werden, wie das in Fig. 2 beschrieben wurde, womit versenkte Kontakte hergestellt werden können.

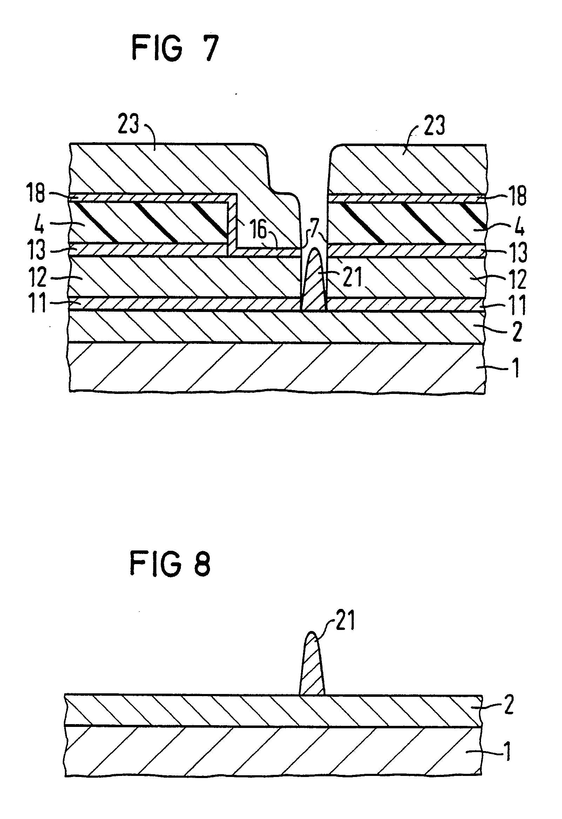

In Fig. 7 sind auf der Halbleiterschicht 2 innerhalb der Lücke 7 Kontakte 21 z. B. mittels Aufdampfen abgeschieden. Bei dieser Abscheidung bildet sich gleichzeitig oberhalb der Fotolackmaske 4 bzw. auf den dritten Titanschichten 16 bzw. 18 eine Kontaktschicht 23.

In Fig. 8 sind alle Schichten oberhalb der Halbleiterschicht 2 mit Ausnahme der Kontakte 21 entfernt. Dabei können die dritten Titanschichten 18 und Kontaktschichten 23 auf der Fotolackmaske 4 z. B. mittels Quellen und Abheben der Fotolackmaske 4 (Abhebetechnik) entfernt werden. Anschließend kann die zweite Titanschicht 13 sowie die dritte Titanschicht 16 aus den Lücken der Fotolackmaske 4 mittels Ätzen entfernt werden. Ebenso kann die Kupferschicht 12 und die erste Titanschicht 11 z. B. mittels verschiedener Ätzverfahren abgetragen werden.

Falls bei den Kontakten 21 eine Titanschicht erwünscht ist oder zumindest nicht stört, kann die erste Titanschicht 11 innerhalb der Lücke 7 bei Fig. 6 erhalten bleiben und es kann darüber die Abscheidung der Kontakte 21 vorgenommen werden.

Das in den Fig. 4 bis 8 beschriebene Ausführungsbeispiel des erfindungsgemäßen Verfahrens kann auch so variiert werden, daß anstelle der ersten Titanschicht 11 und der Kupferschicht 12 eine Lackschicht abgeschieden wird. Bei der Verwendung von Lackschichten können dann anstelle von Ätzungen auch Veraschungen vorgenommen werden.

Die Kontakte 10 und 21 können z. B. als Titan-Platin-Gold-Kontakte oder als Molybdän-Gold-Kontakte oder als Wolfram-Gold-Kontakte oder als Titan-Wolfram-Molybdän-Gold-Kontakte ausgebildet sein.

Zur Herstellung von Galliumarsenid-Feldeffekttransistoren nach dem in den Fig. 1 bis 3 dargestellten Verfahren wird ein semiisolierendes Galliumarsenid-Substrat mit einer stark dotierten Kontaktschicht und mit einer darunter gelegenen schwächer dotierten aktiven Schicht, erzeugt durch Epitaxie oder Ionenimplantation, versehen. Die Begrenzung der leitfähigen Schichten kann mittels einer Fotolackmaske und Mesaätzung erfolgen. Im Fall der Implantation können auch die Teile der Oberfläche des semiisolierenden Substrats, die isolierend bleiben sollen, zuvor mit Fotolack abgedeckt werden. Zum Ausheilen der implantierten Schicht wird eine Schicht von z. B. 200 nm $Si_3N_4$ aufgesputtert. Auch im Fall der Epitaxie wird eine ähnliche isolierende Schicht aufgebracht. Mittels Fototechnik wird an denjenigen Stellen, an denen Source und Drain angebracht werden, zunächst die $Si_3N_4$-Schicht z. B. mittels Ätzung im $CF_4$-Plasma entfernt und anschließend ohmsche Kontakte aufgebracht und anlegiert. Eine nachfolgende Fototechnik, die, wie in Fig. 1 dargestellt, Lücken 5 von einer Breite von ca. 1 μm als Gatestreifen sowie zugehörige Leitungsbahnen freiläßt, wird einer gerichteten Titanbedampfung ausgesetzt. Der Einfallwinkel α der gerichteten Titanbedampfung gegen die Scheibensenkrechte beträgt vorzugsweise 10° bis 20°; die Bedampfung erfolgt in einer Schichtdicke von ca. 10 nm. Durch diese gerichtete Bedampfung bilden sich im Schattenbereich der Fotolackkanten zwischen gewissen Fotolackkanten und der aufgedampften Titanschicht Lücken 7, wie in Fig. 1 dargestellt, mit einer Breite von ca. 0,3 μm aus. In den Lücken 7 ist die $Si_3N_4$-Schicht nicht von der aufgedampften Titanschicht bedeckt und kann deshalb z. B. mittels eines $CF_4$-Plasmas weggeätzt werden. Anschließend kann in der Lücke 7 die stark dotierte Kontaktschicht 22 mit weggeätzt werden, so daß sich die in den Fig. 2 und 3 dargestellten Versenkungen 9 ergeben. Bei einer nachfolgenden Kontaktabscheidung bilden sich die in Fig. 3 dargestellten Kontakte 10 aus, wenn anschließend an die Kontaktabscheidung die Fotolackschicht und darüber befindliche Kontaktschichten mittels Abhebetechnik entfernt werden. Die so erzeugten Kontakte 10 bilden Gates für die hiernach erzeugten Feldeffekttransistoren von einer Gatelänge von 0,1 μm bis 1 μm.

Hiernach gefertigte Feldeffekttransistoren haben den Vorteil, sehr schmale Gatestreifen, nämlich von 0,1 μm bis 1 μm Breite aufzuweisen und haben zugleich den Vorteil, versenkte Gates aufzuweisen.

Das Wegätzen der stark dotierten Schicht 22 unterhalb der Gates bewirkt in vorteilhafter Weise ausreichend große Eindringtiefen der am Gate angelegten elektrischen Felder, während die gute Kontaktgabe unterhalb der Source- und Drainkontakte und der geringe Schichtwiderstand zwischen Source, Gate und Drain erhalten bleiben.

Sind die Titanschichten 6 aus Fig. 2 bei der Herstellung der Kontakte 10 unerwünscht, so können diese auch vor der Kontaktabscheidung entfernt werden.

Als Isolatorschicht 3 lassen sich neben dem oben Genannten auch andere wie etwa SiO, $SiO_2$ oder $Al_2O_3$ verwenden.

Die Verwendung von Titan bei der gerichteten Bedampfung ist nicht zwingend. Es lassen sich vielmehr auch andere ätzresistente Materialien verwenden.

Zur Herstellung des Gatekontakts 10 kommen z. B. Aluminium und/oder Titan und/oder Platin und/oder Gold und/oder Wolfram und/oder Gold in Frage.

Durch das beschriebene Verfahren lassen sich in vorteilhafter Weise rauscharme Galliumarsenid-Feldeffekttransistoren erzeugen.

Das beschriebene Verfahren ist auf die Herstellung von Galliumarsenid-Feldeffekttransistoren durchaus nicht beschränkt. In entsprechender Weise können schmale Schlitze in Schichten erzeugt werden, die als Aufdampfmasken dienen, um beliebige Strukturen von 0,1 μm bis 1 μm Breite und einigen μm Höhe herzustellen.

In den Fig. 4 bis 8 ist ein weiteres Ausführungsbeispiel zur Herstellung sehr feiner, aber andererseits hoher Kontakte auf einem Halbleitersubstrat dargestellt. Dazu wird eine Anordnung nach Fig. 4 mittels eines ätzresistenden Materials wie z. B. Titan gerichtet bedampft, und die Bedampfungsrichtung kann vorzugsweise mit der Scheibensenkrechten einen Winkel α = 10° bis 20° bilden. Dadurch entstehen, wie in Fig. 5 dargestellt, in den Lücken 5 der Fotolackmaske die dritten Titanschichten 16, die wegen der gerichteten Bedampfung wiederum eine Lücke 7 aufweisen. Der unterhalb der Lücke 7 gelegene Teil der Kupferschicht 12 wird z. B. mittels Sputterätzung entfernt, so daß eine Anordnung, wie in Fig. 6 dargestellt, resultiert. Wird anstelle der ersten Titanschicht 11 und der Kupferschicht 12 eine Lackschicht verwendet, so kann der Teil der Lackschicht unterhalb der Lücke 7 durch Veraschen entfernt werden.

Auf der so freigelegten Oberfläche der Halbleiterschicht 2 können dann in an sich bekannter Weise Kontakte aufgebracht werden, die wegen der Feinheit der Lücke 7 Breiten von 0,1 μm bis 1 μm aufweisen (vgl. Fig. 7). Nach Entfernen der übrigen auf der Halbleiteroberfläche aufgebrachten Schichten, z. B. Entfernen der Fotolackmaske 4 und darauf angebrachter Metallschichten mittels Abhebetechnik, Entfernen der zweiten Titanschicht 13 und der dritten Titanschicht 16, z. B. mit einer stark verdünnten Mischung von Flußsäure und Salpetersäure, Entfernen der Kupferschicht 12 mittels Sputterätzen und Entfernen der restlichen Titanschicht 11 mit der angeführten Ti-Ätze bzw. Entfernen der Lackschicht, die anstelle der Kupferschicht und der ersten Titanschicht aufgebracht sein kann, mittels Veraschen, bleiben schließlich die feinen angebrachten Kontakte 21 auf der Halbleiterschicht 2 in gewünschter Weise stehen, während alle anderen Schichten entfernt sind. Ähnlich, wie im Ausführungsbeispiel nach den Fig. 1 bis 3, können auch bei dem Ausführungsbeispiel nach den Fig. 4 bis 8 die Kontakte 21 als versenkte Kontakte auf der Halbleiterschicht 2 angebracht sein, wenn in diese vor der Kontaktabscheidung Versenkungen eingeätzt werden.

Das erfindungsgemäße Verfahren beschränkt sich nicht allein auf die Herstellung von Feldeffekttransistoren. Es kann vielmehr auch bei der Herstellung einer Gunnlogik oder allgemein bei Verdrahtungen mit sehr feinen Strukturen zwischen 0,1 μm bis 1 μm verwendet werden.

## Patentansprüche

1. Verfahren zur Erzeugung von extremen Feinstrukturen auf einem Substrat und von einer Maske mit extremen Feinstrukturen, bei dem auf dem Substrat mindestens eine Schicht (3 ; 11, 12, 13) aufgebracht wird, bei dem auf die mindestens eine Schicht (3 ; 11, 12, 13) eine Fotolackschicht (4) aufgebracht und mittels Fototechnik strukturiert wird, bei dem auf das so erzeugte Gebilde ätzresistentes Material (6, 8 ; 16, 18) unter einem gegen die Substratnormale spitzen Winkel (α) abgeschieden wird, bei dem eine Ätzung mindestens einer nicht von der ätzresistenten Schicht (6, 8 ; 16, 18) bedeckten Schicht (3 ; 11, 12, 13), die zwischen Substrat und Fotolackschicht (4) angeordnet ist, erfolgt, bei dem anschließend die extremen Feinstrukturen abgeschieden werden und bei dem die Fotolackmaske (4) mittels Abhebetechnik entfernt wird, dadurch gekennzeichnet, daß in der Fotolackschicht (4) Lücken (5) erzeugt werden, und daß unter einem solchen spitzen Winkel (α) das ätzresistente Material (6 ; 16) abgeschieden wird, daß infolge der Schattenwirkung der Begrenzungswändde der Fotolackschicht (4) in den Lücken (5) eine zweite Maske abgeschieden wird.

2. Verfahren nach Anspruch 1, dadurch gekennzeichnet, daß das Substrat ein Halbleitersubstrat ist.

3. Verfahren nach Anspruch 1 oder 2, dadurch gekennzeichnet, daß auf eine Halbleiteroberfläche eine Isolatorschicht (3) abgeschieden wird, daß nach dem Aufbringen des ätzresistenten Materials (6, 8) die freiliegenden Teile der Isolatorschicht (3) weggeätzt werden und daß auf die von Isolatormaterial freigeätzte Halbleiteroberfläche Kontaktmaterial (10) abgeschieden wird.

4. Verfahren nach Anspruch 1 oder 2, dadurch gekennzeichnet, daß auf eine Halbleiteroberfläche eine erste Schicht (11) aus ätzresistentem Material und eine Schicht (12) aus ätzbarem Material aufgebracht werden, daß darüber eine weitere Schicht (13) aus ätzresistentem Material abgeschieden wird, daß darüber eine Fotolackmaske (4) abgeschieden wird, daß danach in den nicht vom Fotolack (4) bedeckten Teilen die weitere Schicht (13) aus ätzresistentem Material entfernt wird, daß danach eine dritte Schicht (16, 18) aus ätzresistentem Material unter dem spitzen Winkel (α) auf das so erzeugte Gebilde abgeschieden wird, daß danach freiliegende Teile mindestens einer Schicht, die nicht von der dritten Schicht (16) aus ätzresistentem Material bedeckt sind, entfernt werden, daß danach Kontaktmaterial (21) auf die freigelegte Halbleiteroberfläche oder auf die Oberfläche der ersten Schicht (11) aus ätzresistentem Material abgeschieden wird, daß anschließend mittels Abhebetechnik die Fotolackmasse (4) entfernt wird, daß danach die weitere Schicht (13) aus ätzresistentem Material entfernt wird, daß die Schicht (12) aus ätzbarem Material entfernt wird und daß sodann die erste Schicht (11) aus ätzresistentem Material entfernt wird.

5. Verfahren nach Anspruch 1 oder 2, dadurch gekennzeichnet, daß auf die Halbleiteroberfläche eine Schicht bestehend aus einem veraschbaren Material aufgebracht wird, daß darüber eine Schicht aus ätzresistentem Material abgeschieden wird, daß darüber eine Fotolackmaske (4) abgeschieden wird, daß danach in den nicht vom Fotolack (4) bedeckten Teilen die Schicht aus ätzresistentem Material entfernt wird, daß danach eine weitere Schicht aus ätzresistentem Material unter dem spitzen Winkel (α) auf das so erzeugte Gebilde abgeschieden wird, daß danach freiliegende Teile, die nicht von der weiteren Schicht aus ätzresistentem Material bedeckt sind, entfernt werden, daß danach Kontaktmaterial (21) auf die freigelegte Halbleiteroberfläche abgeschieden wird, daß anschließend mittels Abhebetechnik die Fotolackmaske (4) entfernt wird, daß danach die Schicht aus ätzresistentem Material entfernt wird, und daß danach die auf die Halbleiteroberfläche aufgebrachte veraschbare Schicht abgelöst bzw. verascht wird.

**Claims**

1. A method for the production of extremely fine structures on a substrate and of a mask with extremely fine structures, in which at least one layer (3 ; 11, 12, 13) is applied to the substrate, a photolacquer layer (4) is applied to said at least one layer (3 ; 11, 12, 13) and is structured using a phototechnique, etch-resistant material (6, 8 ; 16, 18) is deposited on the structure which has been so produced at an acute angle (α) relative to the normal substrate, etching is carried out of a least one layer (3 ; 11, 12, 13) which is not covered by the etch-resistant layer (6, 8 ; 16, 18) and which is arranged between the substrate and the photo-lacquer layer (4), the extremely fine structures are then deposited, and the photo-lacquer mask (4) is removed by a lifting technique, characterised in that gaps (5) are produced in the photo-lacquer layer (4), and that the etch-resistant material (6 ; 16) is deposited at an acute angle (α) such that, owing to the shadow effect of the boundary walls of the photo-lacquer layer (4), a second mask is deposited in the gaps (5).

2. A method as claimed in Claim 1, characterised in that the substrate is a semiconductor substrate.

3. A method as claimed in Claim 1 or Claim 2, characterised in that an insulating layer (3) is deposited on to a semiconductor surface ; that after the application of the etch-resistant material (6, 8), the exposed parts of the insulating layer (3) are etched away ; and that contact material (10) is deposited on to the semiconductor surface from which insulating material has been etched away.

4. A method as claimed in Claim 1 or Claim 2, characterised in that a first layer (11) consisting of etch-resistant material and a layer (12) consisting of etchable material are applied to a semiconductor surface ; that on to these layers there is deposited a further layer (13) consisting of etch-resistant material, and on to this further layer there is deposited a photo-lacquer mask (4) ; that the further layer (13) consisting of the etch-resistant material is then removed at those parts which are not covered by the photo-lacquer (4) ; that a third layer (16, 18) consisting a etch-resistant material in then deposited at the acute angle (α) on to the structure so produced ; that exposed parts of at least one layer which are not covered by the third layer (16) of etch-resistant material are then removed ; that contact material (21) is the deposited on to the exposed semiconductor surface, or on to the surface of the first layer (11) consisting of etch-resistant material ; that the photo-lacquer mask (4) is then removed by means of a lifting technique ; that the further layer (13) consisting of etch-resistant material is then removed ; that the layer (12) consisting of etchable material is removed ; and that the first layer (11) consisting of etch-resistant material is then removed.

5. A method as claimed in Claim 1 or Claim 2, characterised in that a layer consisting of an incineratable material is applied to the semiconductor surface ; that on to this layer there is deposited a layer consisting of etch-resistant material, on to which a photo-lacquer mask (4) is then deposited ; that the layer consisting of etch-resistant material is removed at those parts which are not covered by the photo-lacquer (4) ; that a further layer consisting of etch-resistant material is then deposited at the acute angle (α) on to the structure so formed ; that exposed parts which are not covered by the further layer of etch-resistant material are then removed ; that contact material (21) is then deposited on to the exposed semiconductor surface ; that the photo-lacquer mask (4) is then removed by means of a lifting technique ; that the layer of etch-resistant material is then removed ; and that the incineratable layer which has been applied to the semiconductor surface is then stripped off or incinerated.

## Revendications

1. Procédé pour réaliser des structures extrêmement fines sur un substrat, et un masque possédant des structures extrêmement fines, selon lequel on dépose sur le substrat au moins une couche (3 ; 11, 12, 13), on dépose une couche de laque photosensible (4) sur ladite couche (3 ; 11, 12, 13) et on la structure à l'aide d'une technique de photogravure, on dépose sur l'article ainsi obtenu un matériau (6, 8 ; 16, 18) résistant à la corrosion, sous un angle aigu (α) par rapport à la normale au substrat, on réalise une attaque chimique d'au moins une couche (3 ; 11, 12, 13), qui n'est pas recouverte par la couche (6, 8 ; 16, 18) résistant à la corrosion et qui est disposée entre le substrat et la couche de laque photosensible (4), on dépose ensuite les structures extrêmement fines et on élimine le masque de laque photosensible (4) au moyen d'une technique de décollement, caractérisé par le fait qu'on réalise des vides (5) dans la couche de vernis photosensible (4) et que l'on dépose le matériau (6 ; 16) résistant à la corrosion, sous un angle aigu (α) tel que par suite de l'effet de masquage des parois limites de la couche de vernis photosensible (4), un second masque est déposé dans les vides (5).

2. Procédé suivant la revendication 1, caractérisé par le fait que le substrat est un substrat semiconducteur.

3. Procédé suivant la revendication 1 ou 2, caractérisé par le fait qu'on dépose une couche isolante (3) sur une surface semiconductrice, qu'après le dépôt du matériau (6, 8) résistant à la corrosion, on élimine par attaque chimique les parties à nu de la couche isolante (3) et qu'on dépose un matériau de contact (10) sur la surface semiconductrice sur laquelle le matériau isolant a été enlevé par attaque chimique.

4. Procédé suivant la revendication 1 ou 2, caractérisé par le fait qu'on dépose une première couche (11) constituée en un matériau résistant à la corrosion et une couche (12) constituée en un matériau pouvant être corrodé sur une couche semiconductrice, on dépose, sur cet ensemble, une autre couche (13) constituée par un matériau résistant à la corrosion, qu'on dépose, par-dessus, une couche de vernis photosensible (4), qu'on élimine ensuite l'autre couche (13) constituée en un matériau résistant à la corrosion, dans les parties non recouvertes par la laque photosensible (4), qu'on dépose ensuite une troisième couche (16, 18) constituée en un matériau résistant à la corrosion, sous un angle aigu (α) sur l'objet ainsi obtenu, qu'on élimine ensuite des parties à nu d'au moins une couche, qui ne sont pas recouvertes par la troisième couche (16) constituée en un matériau résistant à la corrosion, qu'on dépose ensuite le matériau de contact (21) sur la surface semiconductrice à nu ou sur la surface de la première couche (11) constituée en un matériau résistant à la corrosion, qu'on élimine ensuite le masque de laque photosensible (4) au moyen de la technique de décollement, puis qu'on élimine l'autre couche (13) constituée en un matériau résistant à la corrosion, et qu'on élimine la couche (12) constituée en un matériau pouvant être corrodé et qu'on élimine ensuite la première couche (11) constituée en un matériau résistant à la corrosion.

5. Procédé suivant la revendication 1 ou 2, caractérisé par le fait qu'on dépose une couche constituée en un matériau pouvant être brûlé, sur la surface semiconductrice, qu'on dépose sur cette couche une couche constituée en un matériau résistant à la corrosion, qu'on dépose, par-dessus, un masque de laque photosensible (4) et qu'on élimine ensuite la couche constituée en un matériau résistant à la corrosion dans les parties non recouvertes par la laque photosensible (4), qu'on dépose ensuite une autre couche constituée en un matériau résistant à la corrosion, sous l'angle aigu (α) sur l'article ainsi obtenu, qu'on élimine ensuite des parties à nu, qui ne sont pas recouvertes par l'autre couche constituée en un matériau résistant à la corrosion, qu'on dépose ensuite un matériau de contact (21) sur la surface semiconductrice mise à nu, qu'on enlève ensuite le masque de laque photosensible (4) au moyen d'une technique de décollement, puis qu'on élimine la couche constituée en un matériau résistant à la corrosion et qu'ensuite on fait dissoudre ou on brûle la couche pouvant être brûlée, qui est déposée sur la surface semiconductrice.

## FIG 1

## FIG 2

## FIG 3

# FIG 4

# FIG 5

# FIG 6

# FIG 7

# FIG 8